# EUROPÄISCHE PATENTSCHRIFT

(11) **EP 1 375 048 B1**
(45) Veröffentlichungstag und Bekanntmachung des Hinweises auf die Patenterteilung: **21.05.2008**
(21) Anmeldenummer: 02017859.6
(22) Anmeldetag: 08.08.2002
(51) Int. Cl.: B23K 20/00

(54) **Bondeinrichtung und Drahtbonder**
Wire bonding device
Appareil de microcablage par ultrason

(30) Priorität: 18.06.2002 EP 02013543
(43) Veröffentlichungstag der Anmeldung: 02.01.2004
(73) Patentinhaber: F&K Delvotec Bondtechnik GmbH, 85521 Ottobrunn (DE)
(72) Erfinder: Farassat, Farhad, Dr.-Ing., 82024 Taufkirchen (DE)
(74) Vertreter: Popp, Eugen

(56) Entgegenhaltungen:
- EP-A- 0 649 701
- US-B1- 6 206 275

## Beschreibung

Die Erfindung betrifft eine Bondeinrichtung zum Ultraschall-Drahtbonden sowie deren Verwendung in einem Dickdrahtbonder bzw. einen mit einer solchen Einrichtung ausgerüsteten Drahtbonder.

Nachfolgend wird der Begriff "Bondwerkzeug" im engeren Sinne zur Bezeichnung des die Ultraschallenergie und Druckkraft beim Ultraschall-Drahtbonden auf einen Bonddraht übertragenden Elementes (vielfach auch bezeichnet als Bondkeil oder "Wedge") gebraucht. Daneben wird der Begriff auch in einem weiteren Sinne für eine Kombination eines solchen Werkzeuges mit einem in dieses eingefügten bzw. an dieses dicht angefügten Messer zum Abschneiden eines überstehenden Bonddrahtabschnittes gebraucht.

Bei herkömmlichen Dickdrahtbondern sind das eigentliche Bondwerkzeug zur Druckkraft- und Bondenergieübertragung - speziell der sogenannte "Wedge" - und ein vertikal verfahrbares Messer zum Abschneiden des Bonddrahtes separate Werkzeuge, welche konstruktiv bedingt in einem gewissen lateralen Abstand voneinander an einem Bondkopf angeordnet sind. Speziell das Herstellen von Bondverbindungen vor einer sogenannten "Wand" (also einem vertikal aufstehenden Abschnitt eines Substrates, Bauelementes o.ä.) mit einer solchen Anordnung stößt auf gewisse Schwierigkeiten. Insbesondere sind zwischen der besagten Wand und der Bondverbindung Mindestabstände einzuhalten, die zum Abschneiden des über die Bondverbindung überstehenden Bonddrahtendes mittels des separaten Messers benötigt werden. In der US-A-6 206 275 wird eine Bondeinrichtung offenbart, bei der der Platzbedarf für Bondwerkzeug und Messer vermindert wird.

Der Erfindung liegt die Aufgabe der Bereitstellung einer verbesserten Bondeinrichtung zugrunde, welches insbesondere ein engeres Heranrücken von Bondverbindungen an sogenannte Wände erlaubt.

Diese Aufgabe wird durch eine Bondeinrichtung mit den Merkmalen des Anspruches 1 gelöst. Zweckmäßige Fortbildungen des Erfindungsgedankens ergeben sich auch den abhängigen Ansprüchen.

Die Erfindung schließt weiterhin den Einsatz des vorgeschlagenen Werkzeuges in einem Dickdrahtbonder ein.

Die Erfindung schließt den grundlegenden Gedanken ein, die bei der bisherigen separaten Ausführung des eigentlichen Bondwerkzeuges und des Messers konstruktiv bedingten Mindestabstände zwischen beiden wesentlich zu verringern. Sie schließt weiter den Gedanken ein, zu diesem Zweck das Messer in das eigentliche Bondwerkzeug (Wedge) einzufügen oder es zumindest dicht an dieses anzufügen.

Vorteile und Zweckmäßigkeiten der Erfindung ergeben sich im übrigen aus der nachfolgenden Beschreibung, bevorzugte Ausführungsbeispiele anhand der Figuren. Von diesen zeigen:
- Fig. 1: eine perspektivische Darstellung einer ersten Ausführungsform der Erfindung,
- Fig. 2A und 2B: eine Querschnittsdarstellung bzw. eine perspektivische Darstellung einer speziellen konstruktiven Ausführung eines Bondwerkzeuges (im engeren Sinne) und
- Fig. 3: eine perspektivische Darstellung einer weiteren Ausführungsform der Erfindung.

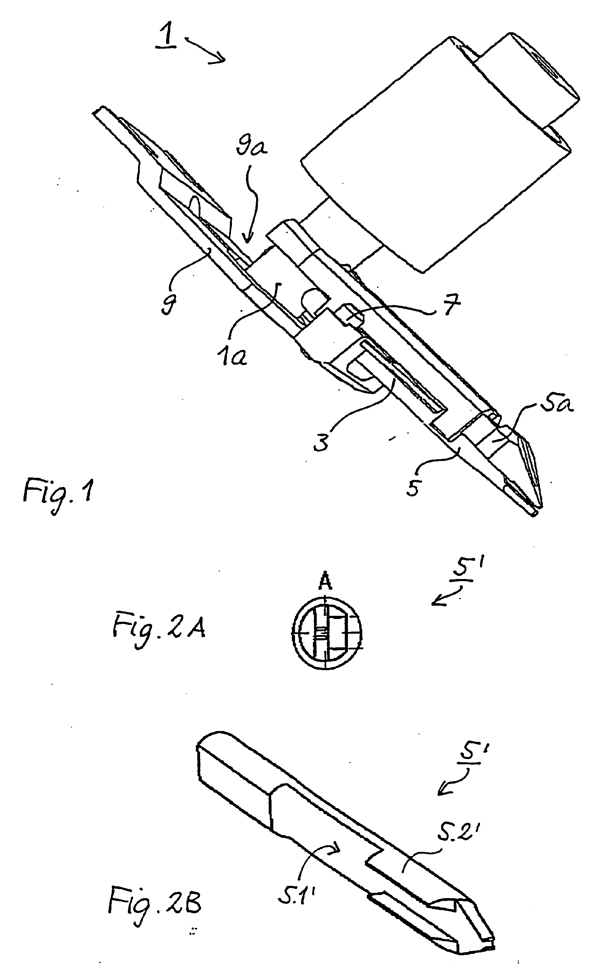

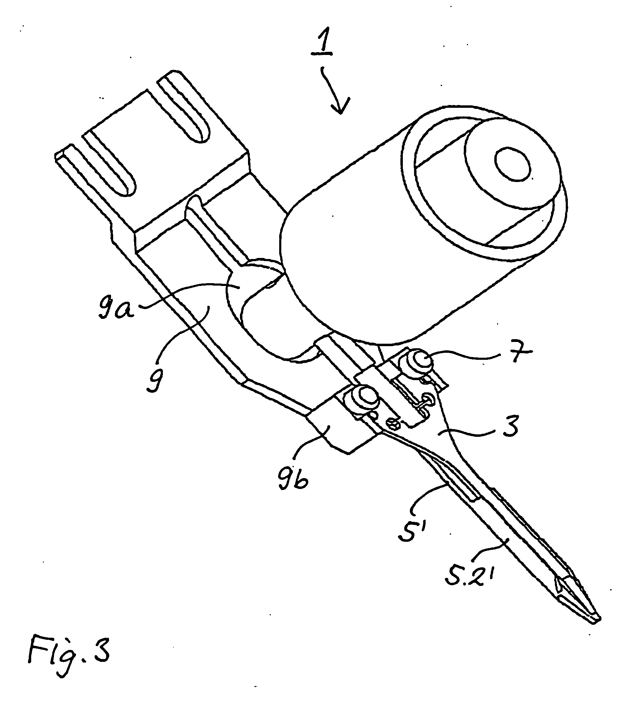

In Fig. 1 ist ein Werkzeughalterabschnitt 1 eines Bondkopfes gemäß einer ersten Ausführungsform der Erfindung dargestellt, bei der ein Messer 3 auf der der Werkzeughalterung bzw. dem (nicht dargestellten) Transducer abgewandten Seite in einen Bondkeil 5 längsverschieblich eingefügt ist. Das Messer 3 ist mit Befestigungsschrauben 7 in seiner Position einstellbar an einem Messerhalter 9 angebracht. Der Bondkeil 5 hat eine U-förmige Drahtführung 5a, in der das Messer 3 seitlich von Fortsätzen umgriffen wird. Eine seitliche Führung bei einer Messerbewegung in Längsrichtung des Bondkeils wird allerdings durch eine geeignete Formgebung des Bondkeils 5 selbst bewirkt; vgl. Fig. 2B und 3.

Der in seiner Grundform annähernd rechteckige Messerhalter 9 ist in Längsrichtung gekröpft und weist im mittleren Bereich eine langlochartige Ausnehmung 9a auf, in die ein über die Ebene der Längserstreckung des Bondkeils 5 hinausragender Fortsatz 1a des Werkzeughalterabschnittes 1 hineinragt, so dass eine störungsfreie Bewegung des Messers relativ zum Werkzeughalterabschnitt, dicht am Bondkeil entlang, ermöglicht wird.

Die Figuren 2A und 2B zeigen einen Bondkeil 5' mit einer gegenüber der Ausführung nach Fig. 1 etwas veränderten Form in einer Querschnittsdarstellung (Fig. 2A) bzw. einer perspektivischen Ansicht (Fig. 2B). Die Neuerung gegenüber bekannten Bondkeilen besteht in einer langgestreckten Ausnehmung 5.1', die in einem mittleren Abschnitt des Bondkeils 5' ohne Seitenwandung ist, während sie in einem sich daran zur Spitze des Bondkeils hin anschließenden Abschnitt von zwei Führungs-Seitenwangen 5.2' begrenzt ist. Die Führungs-Seitenwangen 5.2' bilden einen Führungsabschnitt zur vertikalen Führung des Messers.

In Fig. 3 ist ein zweiter Werkzeughalterabschnitt 1' mit einem Messer 3 des bereits in Fig. 1 gezeigten Aufbaus und einem Bondkeil 5' gemäß Fig. 2A und 2B gezeigt. Die Form des Messers 3 und des Messerhalters 9 sind hier deutlicher zu erkennen als in Fig. 1. Bei dieser Ausführung ist das Messer an der dem Werkzeughalterabschnitt und Transducer zugewandten Fläche des Bondkeils 5' geführt. Der Messerhalter 9 umgreift also mit einem klammerartigen Befestigungsabschnitt 9b, in den die Befestigungsschrauben 7 zur Befestigung des Messers 3 eingedreht sind, den Bondkeil 5'.

Die Ausführungen nach Fig. 1 oder Fig. 3 mit gewissermaßen vertauschter Position von Bondkeil und Messer kommen in Anpassung an die konkret zu realisierende Bondgeometrie in Abhängigkeit vom Anwendungsfall zum Einsatz und sie ermöglichen in jedem Fall ein dichteres Heranrücken von Bondverbindungen an vom Substrat aufstehende Abschnitte oder Bauelemente (die oben erwähnten Wände) und damit eine effizientere Ausnutzung der Substratfläche.

### Bezugszeichenliste

- 1: Werkzeughalteabschnitt
- 1a: Fortsatz
- 3: Messer
- 5; 5': Bondkeil
- 5a: Drahtführung
- 5.1': Ausnehmung
- 5.2': Führungs-Seitenwange
- 7: Befestigungsschraube
- 9: Messerhalter
- 9a: Öffnung
- 9b: Befestigungsabschnitt

## Patentansprüche

1. Bondeinrichtung zum Ultraschall-Drahtbonden, welche ein in Längsrichtung eines als Bondkeil (5; 5') ausgeführten Bondwerkzeuges (5; 5') verschieblich eingefügtes oder dicht angefügtes Messer (3) zum Abschneiden eines überstehenden Bonddrahtabschnittes direkt hinter einer Bondverbindung aufweist, wobei das Messer (3) über eine Schraub- oder Steckverbindung (7) in seiner Position einstellbar an einem Messerhalter (9) angebracht ist, **dadurch gekennzeichnet, daß**
das Bondwerkzeug (5; 5') mit einer sich über mindestens einen Teil seiner Länge erstreckenden Nut (5.1') mit Seitenwangen (5.2') zur vertikalen Führung des Messers versehen ist, und der Messerhalter gekröpft ist, wobei die Kröpfung auf die Geometrie des Bondwerkzeuges und eines Werkzeughalteabschnitts (1) bzw. Transducers derart abgestimmt ist, dass Bondwerkzeug und Messer störungsfrei relativ zueinander bewegbar sind.

2. Bondeinrichtung nach Anspruch 1,
**dadurch gekennzeichnet, dass**
das Messer (3) auf der einem das Bondwerkzeug (5; 5') betätigenden Transducer zugewandten Seite eingefügt ist.

3. Bondeinrichtung nach einem der Ansprüche 1 oder 2,
**dadurch gekennzeichnet, dass**
das Messer (3) auf der einem das Bondwerkzeug (5; 5') haltenden Transducer abgewandten Seite eingefügt ist.

4. Bondeinrichtung nach einem der Ansprüche 1 bis 3,
**dadurch gekennzeichnet, dass**
der Messerhalter (9) eine Öffnung (9a) zum Durchtritt eines , bezogen auf den Transducer, über die vertikale Erstreckungsebene des Bondwerkzeuges (5; 5') hinausragenden Halterungsabschnittes (1a) aufweist.

5. Verwendung einer Bondeinrichtung nach einem der vorstehenden Ansprüche bei einem Dickdrahtbonder.

## Claims

1. Bonding device for ultrasonic wire bonding, which device has, for cutting off a projecting portion of bonding wire directly behind a bonded connection, a knife (3) inserted or closely apposed so as to be displaceable in the longitudinal direction of a bonding tool (5; 5') in the form of a bonding wedge (5; 5'), the knife (3) being mounted on a knife holder (9) so as to be adjustable in terms of its position by means of a screwed or push-in connection (7),
**characterised in that**
the bonding tool (5; 5') is provided with a groove (5.1') extending over at least part of its length and having side cheeks (5.2') for guiding the knife vertically, and the knife holder is cranked, the cranking being so matched to the geometry of the bonding tool and of a tool holding part (1) and/or transducer that the bonding tool and knife are movable relative to one another without interference.

2. Bonding device according to claim 1,
**characterised in that**
the knife (3) is inserted on the side facing a transducer actuating the bonding tool (5; 5').

3. Bonding device according to one of claims 1 or 2,
**characterised in that**
the knife (3) is inserted on the side remote from a transducer holding the bonding tool (5; 5').

4. Bonding device according to one of claims 1 to 3,
**characterised in that**
the knife holder (9) has an opening (9a) for a mounting part (1 a) to pass through, which mounting part extends, relative to the transducer, beyond the plane of the vertical extent of the bonding tool (5; 5').

5. Use of a bonding device according to one of the preceding claims in a thick-wire bonder.

## Revendications

1. Dispositif de soudure pour la soudure de fils par ultrasons qui comporte une lame (3) insérée de manière mobile ou ajoutée de manière étanche dans le sens longitudinal d'un outil de soudure (5 ; 5') réalisé sous forme de coin de soudure (5 ; 5') pour la découpe d'un segment de fil de soudure en saillie directement derrière un assemblage soudé, dans lequel la lame (3) peut être ajustée dans sa position sur un porte-lame (9) à l'aide d'un assemblage à vis ou à fiches (7), **caractérisé en ce que** l'outil de soudure (5 ; 5') est muni d'une rainure (5.1') s'étendant au moins sur une partie de sa longueur avec des faces latérales (5.2') pour le guidage vertical de la lame, et le porte-lame est coudé, le coude étant adapté à la géométrie de l'outil de soudure et d'un segment de support d'outil (1) ou d'un transducteur de telle manière que l'outil de soudure et la lame peuvent se déplacer sans perturbation l'un par rapport à l'autre.

2. Dispositif de soudure selon la revendication 1, **caractérisé en ce que** la lame (3) est insérée sur un côté dirigé vers le transducteur actionnant l'outil de soudure (5 ; 5').

3. Dispositif de soudure selon l'une quelconque des revendications 1 ou 2, **caractérisé en ce que** la lame (3) est insérée sur un côté opposé au transducteur portant l'outil de soudure (5 ; 5').

4. Dispositif de soudure selon l'une quelconque des revendications 1 à 3, **caractérisé en ce que** le porte-lame (9) comporte une ouverture (9a) pour le passage d'un segment de support (1a) faisant saillie à l'extérieur au-dessus du plan d'extension verticale de l'outil de soudure (5 ; 5') par rapport au transducteur.

5. Utilisation d'un dispositif de soudure selon l'une quelconque des revendications précédentes avec une machine de soudure à gros fils.
